# EUROPEAN PATENT APPLICATION

(11) **EP 2 441 857 A2**
(43) Date of publication of application: **18.04.2012**
(21) Application number: 12150630.7
(22) Date of filing: 19.10.2009
(51) Int. Cl.: C23C 14/56, B01J 3/00, A43B 1/00, H01J 37/32, A43B 7/00, A43D 95/10, A43B 7/12, A43D 95/06

(54) **Vacuum processing apparatus**

(30) Priority: 23.10.2008 GB 0819474
(62) Divisional of application: 09740186.3
(71) Applicant: P2i Ltd, Abingdon, Oxfordshire OX14 4SA (GB)
(72) Inventor: King, Charles Edmund, Abingdon, Oxfordshire OX14 4SA (GB)
(74) Representative: Brewster, Andrea Ruth

(57) **Abstract**

An apparatus 10 for vacuum processing articles 12 or for processing articles 12 at an elevated pressure. The apparatus comprises a processing region 14 in which articles can be processed at a processing pressure and a loading region 18 into which articles can be loaded at ambient pressure. Article carriers 20 are provided for carrying articles from the loading region to the processing region along an enclosed passage 24.

The carriers 20 comprise sealing means 34, 36 for sealing against an inner surface of the passage. The sealing means resist the flow of gas along the passage from the loading region to the processing region so that articles loaded at ambient pressure can be processed at processing pressure. The sealing means is disc shaped in order to conform with a pipe with a circular cross section.

## Description

### Field of the Invention

This invention relates to an apparatus for processing an article in a vacuum or under very low pressure conditions, but can also be applied to any differential pressure process.

### Background of the Invention

Low pressure or vacuum processing is widely applied in manufacturing to process or to modify characteristics of material(s) e.g. sputtering of aluminium onto polyester film, nitriding of steels to increase hardness, sputter coating of indium tin oxide onto glass to form transparent electrodes, cold plasma processing to increase reactivity towards adhesives, to apply chemicals to materials or so as to perform some other process to materials or items under low pressure conditions, such as for example, freeze drying them. Examples of above atmosphere processing include sterilising, pasteurisation, rendering, speciality chemical production and the like.

In order to vacuum process products, or interim materials, it is necessary to transfer the products from a holding region at ambient pressure to a treatment chamber at a processing pressure. One way in which transferral can be achieved is simply by placing a product (or batch of products) in a treatment chamber and then evacuating the chamber to processing pressure. Following treatment, the chamber pressure is increased to ambient pressure and the product can be removed. Such a process is inefficient as the pressure in the chamber must be cycled between ambient and processing for each product or batch of products being treated. Cycling pressure requires energy and is time intensive; and therefore product throughput is low unless large and expensive chambers are used. Large chambers with high product density can also be detrimental to uniform processing.

The process can be improved by incorporating one or more load lock chambers in which the pressure cycles between ambient and processing. Products may be transferred from the load lock to the treatment chamber when the load lock chamber is at processing pressure. Products may be transferred to and from the load lock chamber when the load lock chamber is at ambient pressure. This latter process has the advantage that the treatment chamber can be maintained at processing pressure which allows relatively continuous treatment to be achieved. However, in this process the load lock chamber must be cycled between ambient and processing pressure and gate valves with automated carousel movement are required enabling transfer between chambers which increases complexity, cost and potential for faults

If the products are planar, or 2-D (e.g. thin flexible sheets or hard rigid semi-continuous sheets), the products can be transferred to and from the treatment chamber through a number of seals which allow evacuation of the treatment chamber. The seals seal against the flat surface of the planar products when the products pass through the seals. Whistling or labyrinth seals are commonly used for this purpose, which rely on the flatness of the product and consist of multiple, sometimes flexible, seals which press against the product during transfer or are close enough to the product so as to limit ingress of gas from high pressure regions into low pressure regions. Such a process is not suitable for treatment of 3-D products which are not planar, may have irregular shape, be porous or may be easily deformed.

### Prior Art

US Patent US 5 425 264 (Grenci et al) discloses a method for making vacuum components from plastic material, and in particular, PVC and CPVC, where the plastic component is exposed to a high vacuum or ultra high vacuum for an extended period of time, at which time the outgas rate drops considerably to levels that are well within required limits for high vacuum and ultra high vacuum applications.

US-A-2005/0111936 describes a multi-chamber system in which load-lock chambers transfer samples from air into vacuum and robots move samples from one chamber to another. The intention is to reduce footprint, increase throughput, reduce vacuum volume and enable the system to be expanded.

International Patent Application WO-A-2005/0111936 teaches the use of conventional vacuum gates and carriers combined with robotics in a circular arrangement.

Japanese Patent application JP-A-2001196437 also describes a system for transferring substrates using conventional load-locks with vacuum gates and robotic arms. JP-A-2001196437 intends to reduce damage to substrates caused by excessive handling.

### Summary of the Invention

According to a first aspect of the invention there is provided an apparatus for vacuum processing articles comprising:
a fluid passage adapted to receive at least one carrier at a loading region at atmospheric pressure;
carriers having at least one seal which in use defines an intermediate volume within which one or more articles are received for processing;
a processing region defined in said passage, whereat the pressure is low with respect to atmospheric pressure;
a means to displace carriers along the passage, from the loading region to the processing region and subsequently to an exit region; and
at least one pump which, in use, is in fluid communication with the passage and which is operative to reduce the internal pressure of carriers within the passage intermediate said loading region and said processing region and is operative to increase the internal pressure of carriers within the passage intermediate said processing region and said exit region.

Ideally carriers have two seals one positioned at each end thereof.

It is apparent therefore that a gradual reduction in pressure is experienced by the carriers (and their contents) as they pass from the loading region to the processing region. When the carriers arrive at the processing region very low pressure or vacuum processing is able to be performed on articles contained in each carrier. Following processing the carriers are urged to the exit region, which is also at atmospheric pressure, and from where articles are able to be removed from the carriers.

The passage is ideally defined by a wall whose cross section conforms to the seal of the carrier.

Preferably the seals are formed from a deformable flange portion extending around a first end and a second end of the carrier, whereby in use, a pressure differential is created across the flange. The seal, which is ideally disc shaped in order to conform with a pipe with a circular cross section, but can also be cup shaped, is advantageously in the form of a flexible material sandwiched between two flat discs so as to reveal an annulus of flexible material. Seals may be loosely or firmly laminated to provide a combination of characteristics e.g. pressure sealing, ablation resistance, lubricity, material compatibility with processing atmospheres.

Inner walls of the passage are ideally smooth, polished and optionally may be coated with a material, such as poly-tetrafluroethene (PTFE), so as to reduce friction between the seals and the wall, but still maintain an airtight (or near airtight) seal. However reduced friction may also be imparted by micro-roughening of smooth walls. In this instance inner walls so roughened must be in regions where pressure differentials are small i.e. less than 500 mbar and more preferably less than 10 mbar.

Although reference has been made to vacuum or very low pressure processing, it is understood that the invention may be modified for use with pressures above atmospheric pressure.

Thus according to a second aspect of the present invention there is provided an apparatus for processing articles at an elevated pressure, comprising:
a processing region in which articles can be processed at a an elevated processing pressure;
a loading region into which articles can be loaded into the apparatus at ambient pressure; a plurality of article carriers for carrying articles from the loading region to the processing region along an enclosed passage so that articles can be processed at elevated pressure;
wherein said carriers comprise respective sealing means for sealing against an inner surface of the passage when carrying articles along the passage, said sealing means resisting the flow of gas or vapour past said sealing means along said passage from the loading region to the processing region so that articles loaded at ambient pressure in the loading region and carried to the processing region can be processed at the processing pressure.

An advantage of the invention is the lack of need for automated control valves to adjust pressure, because the fluid passage length may be adjusted such that pressure is reduced (or increased) at a desired rate towards the processing region and is allowed to increase (or decrease) at a desired rate towards the exit region. A further advantage is that one or more processes may be carried out in parallel and kept separate one from another, by the seals on each of the carriers.

However valves may be located at intervals, in the wall of the fluid passage and which are connected to one or more pumps which act to reduce the pressure within the volume defined between the seals of a carrier and the wall of the fluid passage.

A control means is optionally provided that operates so as to actuate pumps and/or valves in synchronism with the means to displace the carriers, whereby on displacement of one or more carriers from a first location to a second location, pumps and/or valves are energised so as to at least maintain the pressure differential between a location within a carrier, (as defined by the walls of the fluid passage and the volume intermediate the seals of the carrier), with respect to a location outside the carrier.

Preferably the pressure differential between a location, within a carrier, with respect to a location outside the carrier is increased as a carrier is displaced towards the processing region.

The processing region may be a plasma processing region. Alternatively other low pressure processes may be carried out in the processing region and these include: vacuum deposition and/or etch processes, desiccation, infusion or freeze drying, or any combination that may be useful

Carriers are ideally formed from a rigid material capable of withstanding high compressive forces, typically those created by pressure differentials in excess of 0.1 Mega Pascals (MPa).

Ideally carriers are cylindrical and are adapted to fit inside a pipe or tubular passage and are hollow and shaped to receive items to be treated or processed. The carriers have a seal located around a periphery which is advantageously formed from a material that takes up the shape of the passage and conforms thereto, so that it deforms only to a small extent when the carrier is displaced long the passage. It being understood that an optimum size exists for a given combination of seal type and material, the material forming the wall and a particular pressure regime.

One example of a suitable material that deforms when subjected to a force is polyurethane, which if placed as a flange of thickness of between 2mm to 10 mm, creates an efficient seal. More complex seals may also be used for example composite cross-section polyurethane discs with flexible edges and thicker and stiffer centre sections, or cup-like discs, or composite material seals to reduce friction e.g. polyurethane and PTFE laminate or lubricant doped polyurethane. In all instances seals will interfere with the pipe or tubular passage inner diameter by way of their diameter which is typically between 101 % to 107%greater than inner diameter of the passage.

The means to displace carriers includes: an hydraulic or pneumatic ram arranged to push a train of abutting carriers, an electro-magnetic actuator; a ball-screw or similar actuator, one or more motorised conveyors; and a direct mechanical engagement means, such as inter engaging hooks, taught wire or a rack and pinion system.

Advantageously, the carriers containing articles or product to be processed are arranged so that, in use, one is in direct contact with another, thereby defining a series of carriers or a chain of carriers that are urged along the enclosed passage from the loading region, to the processing region and thence to the exit. This is ideally achieved by application of a uniaxial force, for example from an hydraulic ram that is transmitted from one carrier to an adjacent carrier.

Other preferred and/or optional features of the invention are defined in the accompanying claims.

The invention will now be described, by way of examples only, with reference to the drawings, in which:-

### Brief Description of the Drawings

Figure 1 shows a vacuum processing apparatus;
Figure 2 shows a carrier of the vacuum processing apparatus shown in Figure 1;
Figure 3 shows an alternative vacuum processing apparatus;
Figure 4 shows in diagrammatical form an alternative embodiment of a linear version of the apparatus; and
Figure 5 shows a further alternative embodiment of the apparatus within a closed circuit or loop.

### Detailed Description of the illustrated embodiments

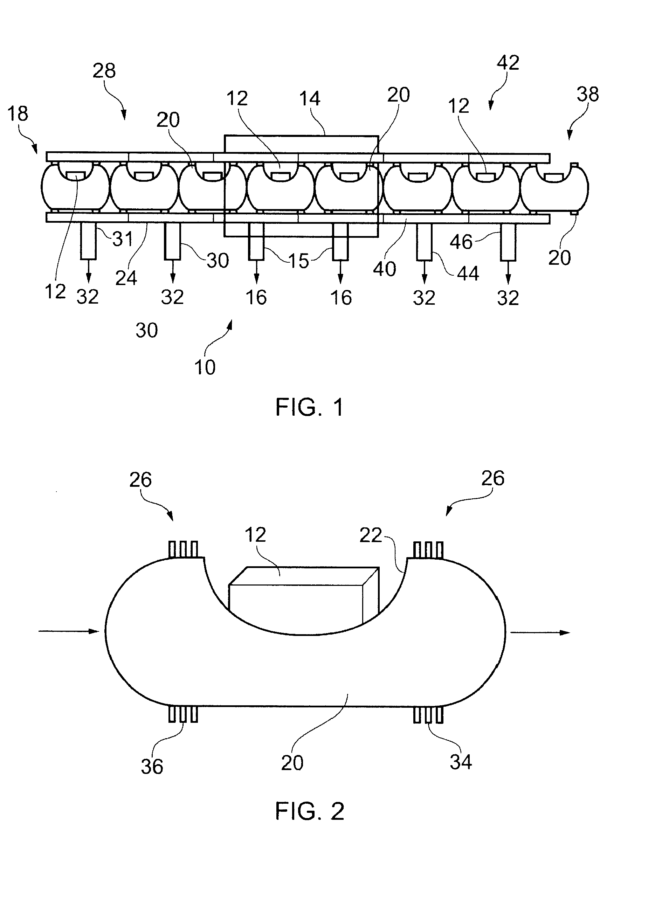

Referring to Figures 1 and 2, apparatus 10 is shown for vacuum processing articles, or product, 12. The processing apparatus is suitable for processing articles at differential pressure to ambient atmosphere up to pressure differential of 3 Bar including low pressure or vacuum, for instance, at pressures in the region of 133 Pa to 0.1 Pa, although pressures outside this range are also applicable. Vacuum processing includes techniques for functionalizing a surface of the articles, such as sputtering, modifying articles (for example by nitriding steels to increase hardness, plasma processing or applying chemicals to articles), as well as desiccating or freeze drying items, such as, pharmaceuticals, foodstuffs and edible items.

Apparatus 10 is particularly suitable for techniques where it is required or desirable to process many articles quickly.

The apparatus 10 comprises a processing region 14 in which articles can be vacuum processed at a very low or near vacuum processing pressure. The processing region is evacuated through vacuum ports 15 by one or more vacuum pumps 16. In addition other pumps or a balanced air extraction system controlled by one or more valves, acts to gradually reduce (or increase) the pressure from an inlet or loading regions (which is at atmospheric or ambient pressure) to the processing region, which is at very low pressure or at vacuum.

The processing region may consist of a vacuum chamber, having openings through which unprocessed articles can be transferred into the chamber and processing articles can be removed from the chamber; alternatively it may be at a high air (or other gas) pressure. The processing region 14 can be generally maintained at a required processing pressure throughout processing of many articles, since as described in more detail below, articles can be transferred to the chamber and removed therefrom without significantly changing the pressure in the processing region.

Articles 12 are loaded into the apparatus 10 at ambient pressure at loading region 18. In this regard, a plurality of article carriers 20 are provided (shown in greater detail in Figure 2) for carrying articles from the loading region 18 to the processing region 14. The carriers 20 comprise respective compartments 22 into which articles to be processed 12 can be loaded. As shown, the carriers are generally elongate, right circular cylinders, but can be any structure with closed ends and whose walls and sides have a strong rigidity. Compartment 22 is formed along a lateral extent of the carrier spaced from each end. The compartments 22 are dimensioned and arranged to comfortably receive articles for processing with sufficient space round the article so that vacuum processing of a large surface area of an article can be achieved in the processing region.

The apparatus 10 is suitable for carrying so-called 3-D articles (i.e. articles which are not planar such as sheets of glass or metal). The carriers are dimensioned and arranged so that the articles typically fit fully within the compartment 22 and therefore do not extend beyond an outer lateral extent of the carrier. It will be appreciated that if an article extends beyond an outer lateral extent of the carrier it may interfere with the inner surface of the passage and prevent sealing by the sealing means (described below).

The carriers 20 carry loaded articles from the loading region 18 to the processing region along an enclosed passage 24. In this embodiment, the enclosed passage 24 is a tube having a generally cylindrical inner surface.

Referring to Figure 2, the carriers 20 comprise respective sealing means 26 for sealing against the inner surface of the passage 24 when the carriers are moved along the passage. Hence, the sealing means provide an obturation in the passage which moves with the carrier from the loading region to processing region and beyond.

The sealing means 26 may comprise one or more seals, such as friction seals, which resist the flow of gas or vapour past the sealing means 26 along the passage from the loading region to the processing region. Accordingly, the sealing means of the carriers enable significant evacuation of the processing region so that articles loaded at ambient pressure in the loading region and carried to the processing region can be vacuum processed at processing pressure.

It will be appreciated that some limited leakage of gas in to the processing region may occur past the sealing means (depending on the quality of the seals). Further, when a carrier enters the processing region the processing region may rise slightly in pressure since, just prior to entry into the processing region, the carrier may be at a pressure greater than the processing pressure. The pressure change is a function of the outgassing characteristics of the product and may also be controlled by choice of the length of the intermediate regions 28 and 42 and quality and number of seals 26.

In Figure 2, the sealing means comprises two seals 34, 36. The first seal 34 is positioned forward of the compartment 22 and seals against the passage forward of the compartment with respect to a direction of travel (shown by arrows in Figure 2). The second seal 36 is positioned rearward of the compartment and seals against the passage rearward of the compartment. Accordingly, seals 34, 36 maintain pressure in the compartment 22. Each seal extends around an outer lateral periphery of the front and rear of the carrier so that the seals can engage the inner surface of the passage 24. If the inner surface of the passage 24 is generally cylindrical (as shown) the seals are generally circular and are preferably 101% to 107% of the inner diameter to correspond with the internal shape of the passage.

To maintain concentricity and so effectiveness of seals 26, at least two portions of outer diameter of carrier 20 may be made between 95% and 99% of the inner diameter of the passage 24. Alternatively a semi rigid spacer disc of similar dimensions may be included in the group of seals 26 which seals are otherwise 101% to 107% of passage 24 inner diameter.

In an alternative arrangement, each carrier 20 may comprise a single seal positioned either forward or rearward of the compartment. In this case, the pressure of a compartment of a carrier is maintained by one seal on that carrier and another seal on an adjacent carrier.

The passage 24 shown in Figure 1 comprises an intermediate pressure region 28 adapted to be maintained at a pressure between ambient pressure and processing pressure. In this regard, the passage has vacuum ports 30, 31 for connection to one or more vacuum pumps 32. Pumps 32 and 16 may be integral and in this case vacuum ports 30, 31 may be connected to an intermediate inlet of the vacuum pump whilst the processing region is connected to the main inlet of the pump.

The intermediate regions provide a more gradual decrease (or increase) in pressure from the loading region to the processing region. In this way, the pressure differential across the sealing means of carriers in the passage is less than the pressure differential between ambient and processing pressure. Accordingly, the provision of several intermediate region(s) between ambient pressure and the processing region means that each seal has to resist a relatively smaller pressure differential. If the processing region is maintained at 13.3 Pa and the loading region at atmosphere, the intermediate region may be maintained at 133 Pa to 13.3 Pa.

The intermediate pressure region 28 comprises two sub-regions at different pressure. A first sub-region is evacuated through vacuum port 31 to a pressure which is higher than a second sub-region which is evacuated through vacuum port 30 so that the pressure in passage 24 decreases in stages towards the processing region. More than two sub-regions may be provided. In general the first sub-region e.g. evacuated through vacuum port 31 will remove the bulk of the air and be independently pumped by a pump 33.

The carriers 20 are arranged in contact one with an adjacent carrier to form a series or chain of carriers along the passage so that movement of one carrier along the passage causes movement of the other carriers in the chain along said passage. The carriers may comprise spacing means for spacing apart the carriers, if required. The carriers can be moved, or pushed, along the passage by for instance a hydraulic ram, located at ambient pressure. Alternatively, the carriers can be connected and pulled along the passage.

Apparatus 10 further comprises an unloading region 38 from which articles 12 can be unloaded from the apparatus at ambient pressure. A second enclosed passage 40 extends from the processing region 14 to the unloading region 38. The second enclosed passage is similar to passage 24 and like features will not be described in detail again for the sake of brevity. Carriers 20 can be moved along the second passage carrying processed articles from the processing region to the unloading region.

Sealing means 26 of the carriers seal against an inner surface of the second enclosed passage 40 when carrying articles along the second passage. The sealing means resists the flow of gas or vapour past the sealing means along the second passage from the unloading region to the processing region so that articles processed at processing pressure and carried to the unloading region can be unloaded at ambient pressure. In this way, the processing region can be maintained generally at processing pressure whilst processed articles are removed from the apparatus.

It will be appreciated that the sealing means in the first passage 24 resist the flow of gas or vapour from the unloaded region to the processing region (i.e. to the right hand side of Figure 1) and in the second passage 40 resist the flow of gas or vapour from the unloading region to the processing region (i.e. to the left hand side of Figure 1). Accordingly, sealing means 26 must be suitable for restricting flow in both directions with respect to the direction of travel of the carriers 20.

Similarly to the first passage 24, the second passage 40 comprises an intermediate pressure region 42 adapted to be maintained at a pressure between ambient pressure and processing pressure so that a pressure differential across the sealing means 26 of carriers in the second passage 40 is less than the pressure differential between ambient and processing pressure.

The intermediate pressure region 42 may comprise a plurality of sub-regions adapted to be maintained at respective pressures from one sub-region to the next along said passage towards said processing region. In this regard, the second passage can be evacuated through vacuum ports 44 and 46. The sub-region associated with port 46 is maintained at a higher pressure than the sub-region associated with port 44 so that pressure in passage 40 is increased in stages from the processing region to the unloading region 38. The second passage 40 may be evacuated by vacuum pump 32.

In a preferred embodiment the intermediate region 42 is not actively pumped except perhaps for one vacuum port adjacent to the processing region 14. In this way any process effluent may be removed from the carriers/product e.g. through vacuum port 44. A gradual rise in pressure will naturally occur in region 42 as carriers progress towards the unloading region 38. The rise in pressure being controlled by the length of the intermediate region 42 and number of seals and carriers. A controller may be arranged to evacuate the passage in synchronism with a stroke of an actuator so that regions either side of seals are pumped efficiently as those regions pass a valve.

Apparatus 10 will now be described in use.

Carriers 20 are positioned as shown in Figure 1 along the first passage 24, through the processing region 14 and along the second passage 40. The sealing means 26 of the carriers 20 seal the processing region from the loading region 18 and the unloading region 38. Vacuum pumps 16, 32 and 33 are operated to evacuate the processing region 14 and passages 24, 40 respectively so that the processing region is at processing pressure and the first and second passages are at an intermediate pressure. Articles 12 are loaded into the compartments 22 of one or more carriers 20 at the loading region 18.

The carriers are then moved along the passages. When the first seal 34 of a carrier passes over vacuum port 31 in the first passage, gas or vapour is evacuated from between the first seal 34 and the second seal 36 thereby reducing pressure in the compartment 22 to a first intermediate pressure (e.g. 150 Pa). When the first seal 34 passes over vacuum port 30 in the first passage, gas or vapour is evacuated from between the first seal 34 and the second seal 36 thereby reducing pressure in the compartment 22 from the first intermediate pressure to a second intermediate pressure (e.g. 15 Pa). Continued movement of the carrier 20 causes the first seal 34 to enter the processing region, at which time gas or vapour is evacuated from between the first seal 34 and the second seal 36 thereby reducing pressure in the compartment from the second intermediate pressure to a processing pressure (e.g. 13 Pa).

Vacuum processing of the articles is conducted in the processing region. The carriers 20 may move continuously or semi-continuously and the length of the processing region must be selected to allow sufficient residence of a carrier in the processing region for processing to be conducted. Alternatively, the carriers 20 may be caused to stop in the processing region for a duration while processing is conducted.

There may be several processing sub-regions along the length of the enclosed passage and each region may have a chosen length so that the residence time of a carrier in each region is sufficient for the appropriate process to be completed. Because all such processes, including loading and unloading of product, are carried out in parallel, the time taken to process a product is dependent substantially on the length of the enclosed passage. The longer the enclosed passage the shorter the process time for any one carrier containing product and so the faster the overall throughput.

Following processing, and assuming no waste gasses are to be removed from carriers the carriers are moved along the second passage 40. When the first seal 34 moves past vacuum port 44, gas or vapour enter between the first seal 34 and the second seal 36 raising the pressure in the compartment 22 to the second intermediate pressure (e.g. 500 Pa). When the first seal 34 moves past vacuum port 46, gas or vapour enters between the first seal 34 and the second seal 36 raising the pressure in the compartment 22 to the first intermediate pressure (e.g. 1000 Pa). When the first seal 34 moves into the unloading region, gas or vapour enters between the first seal 34 and the second seal 36 raising the pressure in the compartment 22 to the ambient pressure (e.g. atmosphere) allowing articles to be unloaded.

A preferred method of operation is not to actively evacuate any of the carriers in the second passage 40, except perhaps to remove waste gases through vacuum port 44. Thereafter in the second passage 40 with no active pumping seals 34 and 36 gradually leak air from the unloading region. The length of passage 40 is chosen so that the leak rate is small and approximately zero leak is seen in the process region.

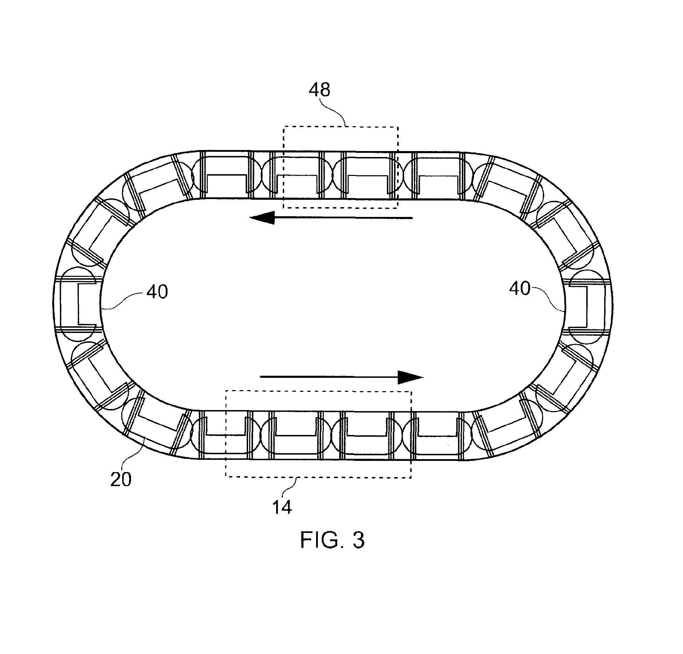

In an alternative arrangement shown in Figure 3, the enclosed passages 24, 40 form a circuit along which the carriers 20 can circulate between an ambient pressure region 48 in which articles can be loaded and unloaded and the processing region 14 maintained at processing pressure in which articles can be processed.

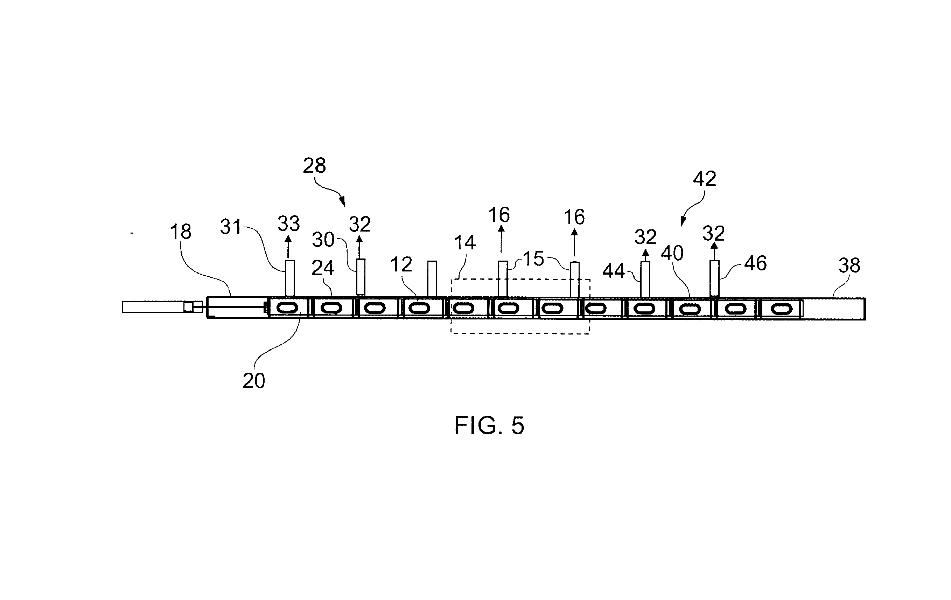

Figure 5 shows an apparatus that comprises a linear closed circuit or loop processing system, in which like parts bear the same reference numerals and which has an automatic off loader 25 and an automatic loader 27. Carriers 20 are urged from an atmospheric entrance or loading position 18 into a passage 24 through which carriers pass to a processing region 14, which is at vacuum or very low pressure. After the items 12 within carriers 20 have been processed, carriers pass to regions of increasing pressure 42 to an exit position 38. At the exit position the passage is cut away and/or a slight incline or some other actuator is provided which causes or permits carriers to move away from the processing passage and to roll or to pass onto a conveyor 50. At the exit region 38 product that has been processed is removed and new, un-processed product is placed into carriers which now pass to region 58 of the conveyor 50.

The conveyor may incorporate any method of conveying carriers back to region 18, e.g. a ram system, wherein carriers are maintained end-to-end and so push one another along the conveyor, or are transported by a belt, air-pressure, or other such movement system where there may be a gap between carriers. Advantageously the conveyor may be enclosed and incorporate one or more pre-conditioning processes that may be applied to product in carriers, e.g. drying, heating, coating, spraying, etc. For vacuum processing of products in region 14 a particularly useful pre-condition step that may be applied along the conveyor 50 is vacuum drying in region 52.

There may be several low pressure stages along the conveyor which separate atmosphere in region 58 to low pressure in region 56 and back to atmosphere in region 25. To effect low pressure in region 56, vacuum ports 54 may be connected to a single pump or multiple pumps 70 to effect outgassing of product as it traverses the conveyor 50. At the exit position 25 the passage is cut away and/or a slight incline or some other actuator is provided which causes or permits carriers 20 to move away from the conveyor passage 50 and to roll or to pass onto the loading region 18 and the cycle starts again.

Advantageously the contents 12 of the carriers - that is items that have been processed - are either presented to someone who removes the items from the carriers at region 38 (for example for packing); or a mechanical means is provided in order to remove the items. Advantageously new items to be processed may replace processed items so that load and unload occur at the same location.

Other variations of a system for performing vacuum processing include a simple linear process line an example of which is shown in Figure 5.

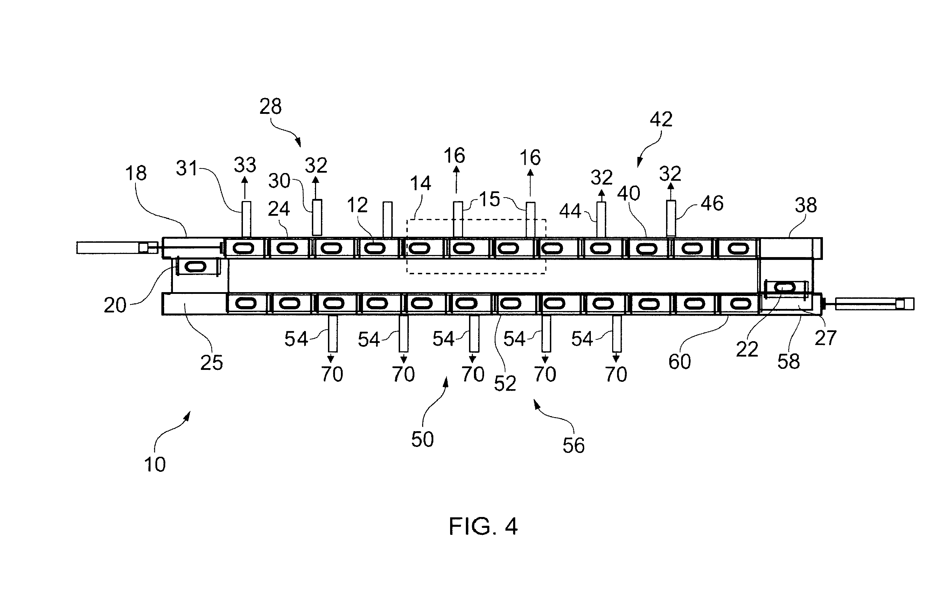

Figure 4 shows an apparatus that comprises a linear processing system, in which like parts bear the same reference numerals and which has a loading position 18 and an unloading position 38. Carriers 20 are urged from an atmospheric entrance or loading position 18 into a passage 24 through which carriers pass to a processing region 14, which is at very low pressure. After the items 12 within carriers 20 have been processed, carriers pass to regions of increasing pressure 42 to an exit position 38 where carriers are removed from the passage 40 and processed product 12 is removed from carriers. Carriers are then transported back to the loading position 18. New un-processed product 12 is placed into the carrier aperture 22 and the cycle starts again.

The following example further illustrates the present disclosure:
Example 1: - With reference to Figure 4 and Figure 2, samples 12 of cotton cloth 24cm x 24cm were placed one each into carriers. Carriers 20 are made from polyvinylchloride (PVC) and are 97% of the passage inner diameter and 42cm in length. Polyurethane disc seals 34 Figure 2, 102% of the passage inner diameter are situated at either end of each carrier. Eighteen carriers 20, each containing a sample of cotton cloth were placed consecutively into the loading region 18 and urged into the passage 24 by a ram. A vacuum was applied by three pumps whereby a pressure of 133PA was held at the first vacuum port 33, 250Pa at the first intermediate region 28 and 10Pa in the process region 14. With vacuum achieved a plasma was struck in region 14 using external electrodes; a 13.56 MHz source and a fluoro-monomer was introduced into the same region. Further carriers containing cotton cloth samples were consecutively fed into the loading station and pushed along the length of the passage 24 and also removed from the exit region 38. After 8 carriers had emerged from the exit region, the first "processed" carrier, i.e. having seen plasma and process chemical was pushed out of the exit region 38.

The cotton samples showed hydrophobic effects. Subsequently a further eight carriers were caused to traverse the passage and were satisfactorily processed. The pressure in the process region 14 maintained at approximately 10 Pa.

Example 2: - Shoes are made from materials that typically outgas water and solvents when placed in a vacuum chamber and this outgassing can interfere with CVD and PECVD processes. With reference to regions shown in Figure 5, fifty pairs of sports (training) style shoes were placed one pair each into the carriers and fed to the load station of a closed circuit continuous machine of the present invention. Carriers containing a pair of shoes travelled first through region 52 of the pre-treatment conveyor in which a vacuum of approximately 1200Pa was dynamically applied. Carriers remained in this vacuum drying region for around 6.5 minutes.

Regions 25 and 18 are at atmospheric pressure and are connected and enclosed containing clean, dry air so avoiding water absorption in transferring carriers from the conveyor 50 to the process line regions 28, 14, 42. Carriers were then urged into the process line region 28 and through the process region 14 and so on to the exit region 38. The cycle time for a pair of shoes was 30 seconds and a pressure of 18Pa was maintained in the process region 14. A good uniform process effect was achieved.

Shoes from the same batch were processed using a batch machine and pre-drying shoes using dry air for 10 hours. Process pressure achieved was 30Pa and process cycle time for a pair was 90 seconds. A variable process effect was achieved.

The invention has been described by way of several embodiments, with modifications and alternatives, but having read and understood this description further embodiments and modifications will be apparent to those skilled in the art. All such embodiments and modifications are intended to fall within the scope of the present invention as defined in the accompanying claims.

For example, although reference has been made to processing at very low pressure or vacuum the apparatus may be modified for processing at high pressures. Likewise items other than clothing and sports footwear may be processed. For example, solid items may be processed such as laboratory equipment, such as glassware and other items such as pipettes, tubes and narrow conduits or fluid pathways, where wetting is disadvantageous.

According to an aspect of the present invention, there is provided apparatus for vacuum processing articles, comprising:
a fluid passage adapted to receive at least one carrier at a loading region at atmospheric pressure;
carriers having at least one seal which in use defines an intermediate volume within which one or more articles are received for processing;
a processing region defined in said passage, whereat the pressure is low or high with respect to atmospheric pressure;
a means to displace carriers along the passage, from the loading region to the processing region and subsequently to an exit region; and
at least one pump or pressure differential means which, in use, is in fluid communication with the passage and which is operative to reduce or increase the internal pressure of carriers within the passage intermediate said loading region and said processing region and is operative to increase or reduce the internal pressure of carriers within the passage intermediate said processing region and said exit region.

The cross section of the passage may match the cross section of the carrier.

Seals may be formed from a deformable flange portion extending around a first end and a second end of the carrier, whereby in use, a pressure differential is created across the flange.

Seals may be formed from pneumatic "U", "T" or "V" type seals extending around a first end and a second end of the carrier, whereby in use, a pressure differential is created across the flange.

The seal may be disc shaped in order to conform with a pipe with a circular cross section.

The seal may comprise a flexible material sandwiched between two flat discs and revealing an annulus of flexible material.

The seal may comprise a flexible material compounded with or laminated with a fluoro-polymer such as poly-tetrafluroethane (PTFE) or molybdenum disulphide, so as to reduce friction between the seals and the wall, whilst in use still maintaining an airtight (or near airtight) seal.

The seal may be protected from the process environment by a flexible inert covering, so as to reduce contamination of the process by the seal material, whilst in use still allowing the seal to maintain a gas tight (or near gastight) seal.

Inner walls of the passage are ideally smooth and polished. The walls may be coated with a material, such as poly-tetrafluroethene (PTFE), so as to reduce friction between the seals and the wall, whilst in use still maintaining an airtight (or near airtight) seal.

According to a further aspect of the invention, there is provided apparatus for vacuum processing articles, comprising:
a processing region in which articles can be vacuum processed at a processing pressure;
a loading region into which articles can be loaded into the apparatus at ambient pressure;
a plurality of article carriers for carrying articles from the loading region to the processing region along an enclosed passage so that articles can be vacuum processed;
wherein said carriers comprise respective sealing means for sealing against an inner surface of the passage when carrying articles along the passage, said sealing means resisting the flow of gas or vapour past said sealing means along said passage from the loading region to the processing region so that articles loaded at ambient pressure in the loading region and carried to the processing region can be vacuum processed at processing pressure.

The apparatus may include an actuator arranged to urge carriers along the passage.

Valves may be located at intervals, in the wall of the fluid passage and which are connected to the or each pump, thereby acting to reduce the pressure within the volume defined between the seals of a carrier and the wall of the fluid passage. Such valves may open and close in response to control signal.

The apparatus may be provided with a control means that operates so as to actuate pumps and/or valves in synchronism with the means to displace the carriers, whereby on displacement of one or more carriers from a first location to a second location, pumps and/or valves are energised so as to at least maintain the pressure differential between a location within a carrier, (as defined by the walls of the fluid passage and the volume intermediate the seals of the carrier), with respect to a location outside the carrier.

The processing region may be a plasma processing region. It may be for vacuum deposition. It may be for desiccation. It may be for infusion. It may be for freeze drying.

The carriers are ideally formed from a rigid material capable of withstanding high forces, typically those created by pressure differentials in excess of 0.1 Mega Pascals (MPa).

The inner surface of said passage may be generally cylindrical and said sealing means may be generally circular and extend about a periphery of said carriers.

The carriers may be cylindrical shaped and hollow with an open aperture for loading.

The means to displace carriers may include actuators from the group comprising: an hydraulic ram; a pneumatic ram; an electro-magnetic actuator; a ball or roller screw actuator; one or more motorised conveyors; and a direct mechanical engagement means.

The apparatus may comprise:
an unloading region from which articles can be unloaded from the apparatus at ambient pressure; and
a second enclosed pre-conditioning passage along which said carriers can carry new un-processed articles to the loading region.

In this embodiment, the sealing means of said carriers may seal against an inner surface of said second enclosed pre-conditioning passage so that when carrying articles along the second passage, said sealing means resist the flow of gas or vapour past said sealing means along said second passage from the unloading region to the processing region so that articles are pre-conditioned at processing pressure and carried to the loading region for loading at ambient pressure.

Said second pre-conditioning passage may comprise an intermediate pressure region adapted to be maintained at a pressure between ambient pressure and processing pressure so that a pressure differential across the sealing means of carriers in said second passage is less than the pressure differential between ambient and processing pressure.

Said intermediate pressure region may comprise a plurality of sub-regions adapted to be maintained at respective pressures from one sub-region to the next along said passage towards said processing region.

The enclosed passages may form a circuit along which said carriers circulate between ambient pressure region in which articles can be loaded and unloaded and processing region at processing pressure in which articles can be processed.

According to a yet further aspect of the invention, there is provided a method of vacuum processing articles, comprising the steps of:
loading a carrier with one or more articles to be processed and placing the carrier in a passage at a loading region at atmospheric pressure, said carrier having first and second seals defining an intermediate volume within which one or more articles are received for processing;
urging carriers along the passage from a region of a first pressure to a region of lower pressure until the carrier arrives at a processing region that is substantially a vacuum;
processing said articles that are located in the carrier at the processing region;
displacing carriers from the processing region to an exit region.

A still further aspect of the invention provides an article that has been vacuum processed according to such a method.

## Claims

1. Apparatus for vacuum processing articles or for processing articles at an elevated pressure, comprising:
a fluid passage adapted to receive at least one carrier at a loading region at atmospheric pressure;
carriers having at least one seal;
whereby in use an intermediate volume is defined within which one or more articles are received for processing;
a processing region defined in said passage, whereat the pressure is low or high with respect to atmospheric pressure;
a means to displace carriers along the passage, from the loading region to the processing region and subsequently to an exit region; and
at least one pump or pressure differential means which, in use, is in fluid communication with the passage and which is operative to reduce or increase the internal pressure of carriers within the passage intermediate said loading region and said exit region, **characterised in that** the at least one seal is disc shaped in order to conform with a pipe with a circular cross section.

2. Apparatus as claimed in claim 1, **characterised in that** the at least one seal comprises a flexible material sandwiched between two discs so as to reveal an annulus of flexible material which conforms to the cross section of the fluid passage.

3. Apparatus as claimed in any preceding claim, **characterised in that** the walls are coated with a material, such as poly-tetrafluroethene (PTFE), so as to reduce friction between the seals and the wall, whilst in use still maintaining an airtight (or near airtight) seal.

4. Apparatus as claimed in any preceding claim, **characterised in that** valves are located at intervals, in the wall of the fluid passage and which are connected to the or each pump, thereby acting to reduce or increase the pressure within the volume defined between the seals of a carrier and the wall of the fluid passage.

5. Apparatus as claimed in any preceding claim, **characterised in that** a control means is provided that operates so as to actuate pumps and/or valves in synchronism with the means to displace the carriers, whereby on displacement of one or more carriers from a first location to a second location, pumps and/or valves are energised so as to at least maintain the pressure differential between a location within a carrier, (as defined by the walls of the fluid passage and the volume intermediate the seals of the carrier), with respect to a location outside the carrier.

6. Apparatus as claimed in any preceding claim, **characterised in that** the processing region is selected from a plasma processing region; a vacuum deposition region; a desiccation region; an infusion region; and a freeze drying region.

7. Apparatus as claimed in any preceding claim, **characterised in that** carriers are cylindrical shaped and hollow with an open aperture for loading.

8. Apparatus as claimed in any preceding claim, **characterised in that** the means to displace carriers includes actuators from the group comprising: a hydraulic ram; a pneumatic ram; an electro-magnetic actuator; a ball or roller screw actuator; one or more motorised conveyors; and a direct mechanical engagement means.

9. Apparatus as claimed in any preceding claim, comprising:
an unloading region from which articles can be unloaded from the apparatus at ambient pressure; and
a second enclosed pre-conditioning passage along which said carriers can carry new un-processed articles to the loading region.

10. Apparatus as claimed in claim 9, **characterised in that** said sealing means of said carriers seals against an inner surface of said second enclosed pre-conditioning passage so that when carrying articles along the second passage, said sealing means resist the flow of gas or vapour past said sealing means along said second passage from the unloading region to the processing region so that articles are pre-conditioned at processing pressure and carried to the loading region for loading at ambient pressure.

11. Apparatus as claimed in claim 9 or claim 10, **characterised in that** said second pre-conditioning passage comprises an intermediate pressure region adapted to be maintained at a pressure between ambient pressure and processing pressure so that a pressure differential across the sealing means of carriers in said second passage is less than the pressure differential between ambient and processing pressure.

12. Apparatus as claimed in claim 11, **characterised in that** said intermediate pressure region comprises: a plurality of sub-regions adapted to be maintained at respective pressures from one sub-region to the next along said passage towards said processing region.

13. Apparatus as claimed in any of the preceding claims, **characterised in that** the enclosed passages form a circuit along which said carriers circulate between ambient pressure regions in which articles can be loaded and unloaded and processing region at processing pressure in which articles can be processed.

14. A method of processing articles, comprising the steps of:
loading a carrier with one or more articles to be processed and placing the carrier in a passage at a loading region at atmospheric pressure, said carrier having first and second seals defining an intermediate volume within which one or more articles are received for processing;
urging carriers along the passage from a region of a first pressure to a region of lower or higher pressure until the carrier arrives at a processing region;
processing said articles that are located in the carrier at the processing region;
displacing carriers from the processing region to an exit region.
